# FASCICULE DE BREVET EUROPEEN

(11) **EP 2 900 045 B1**
(45) Date de publication et mention de la délivrance du brevet: **22.05.2019**
(21) Numéro de dépôt: 15152540.9
(22) Date de dépôt: 26.01.2015
(51) Int. Cl.: H05K 7/14, H05K 7/20

(54) **Enceinte de data-center et Installation mettant en oeuvre une telle enceinte**
Gehäuse eines Rechenzentrums, und Anlage zum Einbau eines solchen Gehäuses
Data-centre enclosure and installation implementing such an enclosure

(30) Priorité: 24.01.2014 FR 1450626
(43) Date de publication de la demande: 29.07.2015
(73) Titulaire: Enia Architectes, 93100 Montreuil (FR); Celeste, 77420 Champs Sur Marnes (FR)
(72) Inventeur: Aube, Nicolas, 77420 CHAMPS SUR MARNES (FR); Chazelle, Mathieu, 93100 Montreuil (FR); Pallubicki, Simon, 93100 Montreuil (FR); Piechaczyck, Brice, 93100 Montreuil (FR); Trescartes, Laurent, 93100 Montreuil (FR)
(74) Mandataire: Jacobacci Coralis Harle

(56) Documents cités:
- JP-A- 2012 053 747
- SG-A1- 185 865
- US-A1- 2012 155 027
- US-A1- 2013 058 029
- US-A1- 2013 081 784

## Description

La présente invention concerne le domaine technique des centres de traitement de données ou data-centers et plus particulièrement le domaine des installations ou enceintes, également appelées centres informatiques, destinées à recevoir plusieurs systèmes informatiques tels que des serveurs en leur offrant des conditions de fonctionnement optimales.

Dans le domaine ci-dessus, il est connu de concevoir des bâtiments dédiés à usage exclusif de data-center. Cependant, l'utilisation d'un bâtiment dédié n'est pas toujours adaptée lorsque les besoins en volume d'accueil de serveurs ne sont pas très importants. De plus, de tels bâtiments présentent un coût de construction important qui les rendent inadaptés au besoin d'une PME ou d'une petite ou moyenne collectivité locale. Par ailleurs, en plus du coût inhérent à la conception et la fabrication de tels bâtiments, il se pose le problème de la mise en place d'installations de production d'énergie de secours tels que des groupes électrogènes qui induisent le stockage sur place d'importantes quantités de combustible nécessitant des déclarations spécifiques auprès des autorités locales et imposant des mesures de sécurité onéreuses.

Il est également connu d'aménager un data-center dans les pièces de bâtiments préexistants. Toutefois, la modification d'une ou plusieurs pièce d'un bâtiment préexistant induit des coûts de modification également importants qui peuvent constituer un frein à la mise en place de solutions réellement adaptées pour offrir des niveaux de sécurité et de fiabilité conformes aux préconisations des constructeurs pour la mise en place de data-center.

Il est donc apparu le besoin d'une enceinte de data-center qui possède une conception adaptée pour l'accueil de plusieurs systèmes informatiques tout en présentant un coût de revient inférieur à celui impliqué par la modification d'une pièce d'un bâtiment préexistant et très inférieur à celui de la construction d'un bâtiment dédié. Afin d'atteindre cet objectif des demandes US2013/00558029 et JP2012 053747 ont proposé de mettre en oeuvre un enceinte de data-center de forme générale parallélépipédique rectangle au gabarit routier, allongée selon un axe horizontal, comprenant des baies d'accueil de systèmes informatiques chacune de forme générale parallélépipédique rectangle allongée selon un axe vertical. Cependant les enceintes selon l'art antérieur présentent de nombreux défauts notamment en ce qui concerne la mise en place et le changement des baies ou des serveurs qu elles contiennent de sorte qu'il apparu le besoin d'apporter une solution à ces problèmes.

Afin d'atteindre cet objectif l'invention concerne une enceinte de data-center de forme générale parallélépipédique rectangle au gabarit routier, allongée selon un axe horizontal, comprenant des baies d'accueil de systèmes informatiques chacune de forme générale parallélépipédique rectangle allongée selon un axe vertical caractérisée en ce qu'elle comprend à l'intérieur de l'espace qu'elle délimite :
- au moins quatre baies d'accueil de systèmes informatiques et/ou de télécommunications qui contribuent à délimiter dans l'enceinte une zone froide à l'avant des baies d'accueil et une zone chaude à l'arrière des baies d'accueil, qui sont juxtaposées en épi et dont un plan sagittal forme un angle aigu compris entre 35° et 85° avec l'axe longitudinal de l'enceinte,
- et un cloisonnement intérieur qui sépare la zone froide de la zone chaude et qui intègre les baies d'accueil, le cloisonnement intérieur étant adapté pour que la circulation de l'air entre la zone froide et la zone chaude se fasse principalement au travers des baies d'accueil,
la disposition des baies d'accueil (25) étant adaptée pour permettre un retrait et une insertion, dans le cloisonnement intérieur (26), de l'une des baie ainsi qu'une évacuation à l'extérieur de l'enceinte de ladite baie par une porte d'accès (20) située au niveau d'une paroi latérale extrême de l'enceinte, sans déplacer les autres baies d'accueil (25).

Au sens de l'invention une enceinte comprend des parois qui permettent de contrôler l'accès au volume qu'elle délimite de manière à empêcher cet accès à des personnes non habilitées.

La mise en oeuvre d'une enceinte au gabarit routier permet d'envisager une fabrication standard en série sur un lieu de production industrielle pour ensuite permettre un transport de ladite enceinte par la route jusqu'à son site d'installation. Ainsi, la production en série permet une réduction substantielle des coûts tandis que la possibilité de transport routier hors convoi exceptionnel facilite l'acheminement de l'enceinte vers son lieu de mise en oeuvre. De plus, la conception de l'enceinte permet de faciliter les opérations de retrait et de remise en place d'une baie d'accueil complète mais également les opérations de retrait et de mise en place de systèmes informatiques tels que des serveurs, dits serveurs rack, adaptés pour les baies informatiques de 19 pouces munis de rails d'adaptation sur les montants de la baie ou des serveurs, dits serveurs lame, à enficher dans des châssis d'accueil de serveur, lesdits châssis étant adaptés pour une mise en place dans les baies informatiques de 19 pouces.. Par ailleurs, il doit être noté que l'enceinte selon l'invention, adaptée pour être stockée et mise en oeuvre à l'extérieur sans protection contre les intempéries, permet de réaliser un data-center de petite taille adapté pour une mise en oeuvre dans un environnement de PME ou de collectivité locale et permettant l'utilisation en tant que source d'énergie de secours un groupe électrogène possédant une autonomie de fonctionnement d'un ou plusieurs jours avec une capacité de carburant très nettement inférieure à celle soumise à déclaration d'installation classée pour l'environnement compte tenu de la puissance nécessaire pour alimenter tous les équipements de l'enceinte. De plus, la surface de plancher inférieure à 20 m² ne nécessite qu'une déclaration préalable de travaux en France. Par ailleurs, en cas de mise en oeuvre d'un système de traitement et de refroidissement de l'air, ce dernier aura une puissance inférieure à celle soumise à déclaration d'installation classée pour l'environnement. La mise en place de l'enceinte peut alors être effectuée avec une simple déclaration préalable de travaux auprès de la Mairie.

De manière préférée et chaque enceinte selon l'invention comprend un circuit de distribution électrique vers les baies d'accueil de systèmes informatiques et des appareillages accessoires adapté pour supporter et distribuer une puissance inférieure ou égale à 100 kW. L'enceinte de data-center comprend alors des moyens de raccordement du circuit ou câblage de distribution électrique à, d'une part, au moins un réseau de distribution électrique externe et, d'autre part, à un groupe électrogène de secours. Bien entendu, l'utilisation d'un tel groupe électrogène n'est pas nécessaire à la mise en oeuvre d'une enceinte de data-center selon l'invention.

Par ailleurs, dans la mesure où l'enceinte selon l'invention constitue « un bâtiment autonome » à accès contrôlé se trouvant en milieu ouvert et présente un faible volume bien confiné, il est possible d'y intégrer des systèmes de protection contre l'incendie à gaz qui permettent de préserver les équipements électriques et informatiques. De plus, la mise en oeuvre de l'enceinte selon l'invention en milieu ouvert, en extérieur, limite en cas d'incendie une propagation depuis ou vers un autre bâtiment.

Selon une caractéristique de l'invention, la plus petite distance entre la face avant d'une baie d'accueil et la paroi en regard de l'enceinte est supérieure ou égale à 90 cm.

Selon une autre caractéristique de l'invention, chaque baie d'accueil possède une largeur supérieure ou égale à 60 cm, une profondeur supérieure ou égale à 90 cm et une hauteur supérieure ou égale à 1,90 m.

Selon caractéristique de l'invention, l'enceinte de data-center possède une largeur hors-tout supérieure à 230 cm, une longueur hors-tout supérieure à 500 cm et une hauteur hors tout comprise entre 220 cm et 300 cm.

Selon une autre caractéristique de l'invention, les parois latérales et la paroi supérieure, au moins, de l'enceinte comprennent un isolant thermique. La mise en oeuvre de telles parois isolées thermiquement permet de mieux contrôler la température interne de l'enceinte.

Selon encore une autre caractéristique de l'invention, le cloisonnement intérieur de l'enceinte comprend une porte d'accès à la zone chaude à partir de la zone froide. La zone froide est de préférence la zone où les techniciens de maintenance interviennent le plus longtemps, aussi le fait d'aménager l'accès à la zone chaude à partir de la zone froide permet de conférer à la zone froide une surface utile supérieure à celle de la zone chaude.

Selon caractéristique de l'invention, l'enceinte comprend une porte d'accès située au niveau d'une paroi latérale extrême de l'enceinte et donnant accès à la zone froide depuis l'extérieur de l'enceinte.

Selon une autre caractéristique de l'invention, une paroi latérale de l'enceinte comprend au moins une ouverture de circulation d'air chaud et au moins une ouverture de circulation d'air froid. La mise en oeuvre de telles ouvertures de circulation d'air dans une paroi latérale de l'enceinte permet de disposer des moyens de traitement d'air à l'extérieur de l'enceinte de manière à ne pas occuper une partie du volume intérieure de cette dernière et à pouvoir raccorder ces moyens de traitement l'air à l'enceinte uniquement sur son lieu d'utilisation de sorte que l'enceinte conserve son gabarit routier avant sa mise en oeuvre.

Selon une variante de cette caractéristique, la paroi latérale de l'enceinte, comprenant les ouvertures de circulation d'air chaud et d'air froid, est située du coté de la zone chaude. Cette variante permet de limiter la distance de raccordement de la zone chaude à des moyens de traitement de l'air manière à créer une dépression dans la zone chaude et à limiter les pertes de charge sur le circuit d'air chaud.

Dans le cadre de cette variante, l'enceinte peut comprendre, dans la zone chaude, une gaine de circulation d'air froid qui est raccordée à l'ouverture de circulation d'air froid et qui débouche dans la zone froide.

La gaine de circulation d'air froid peut être réalisée de toute manière appropriée et, par exemple, définie en partie au moins par une paroi supérieure de l'enceinte et un faux-plafond. De manière préférée mais non exclusive, la gaine de circulation d'air froid possède une hauteur supérieure ou égale à 10 cm. Une telle dimension permet de limiter les pertes de charges.

Selon une caractéristique de l'invention, la gaine soufflage débouche dans la zone froide au dessus des baies d'accueil.

L'invention concerne aussi une installation de data-center comprenant au moins une enceinte de data-center selon l'invention et au moins une unité de traitement de l'air raccordée aux zones chaude et froide.

L'invention concerne également une enceinte de data-center selon l'invention et au moins une unité de traitement de l'air qui est fixée à la paroi latérale pourvue des ouvertures de circulation de l'air et qui est adaptée pour aspirer l'air à traiter par l'ouverture de circulation de l'air chaud et refouler de l'air traité par l'ouverture de circulation d'air froid.

L'invention concerne aussi une installation de data-center comprenant au moins une enceinte de data-center selon l'invention et au moins une unité de traitement de l'air qui est fixée à la paroi latérale pourvue des ouvertures de circulation de l'air et à l'intérieur de laquelle l'air circule sous l'effet de la différence de pression entre la zone froide et la zone chaude. Un tel mode de mise en oeuvre met à profit la surpression induite dans la zone froide par le soufflage de chaque unité de traitement d'air. Les systèmes informatiques sont alors refroidis par le fonctionnement de leurs ventilateurs qui aspirent l'air de la zone froide pour le refouler dans la zone chaude après lui avoir fait traverser les zones ou les éléments à refroidir.

Selon une caractéristique de l'invention, l'unité de traitement de l'air peut ne pas utiliser de fluide frigorigène pour le refroidissement de l'air. Ainsi selon une caractéristique de l'invention, l'installation de data-center mettant en oeuvre l'enceinte conforme à l'invention peut fonctionner à pleine charge sans production de froid par l'unité de traitement de l'air

Selon une autre caractéristique de l'invention, l'enceinte de data-center est dépourvue de canalisation de circulation d'un liquide de refroidissement à l'intérieur de l'enceinte.

Selon une autre caractéristique de l'invention, l'unité de traitement de l'air est adaptée pour prélever de l'air extérieur et l'introduire dans l'enceinte pour en assurer le refroidissement.

Selon une autre caractéristique de l'invention, l'enceinte est associée à une structure extérieure, dite ombrière, de protection contre le rayonement direct du soleil. La position de l'ombrière est adaptée à la latitude du lieu d'installation afin de baisser les besoins en rafraichissement. Dans une forme préférée de réalisation mais non nécessaire, l'ombrière est solidaire à la structure basse de l'enceinte mais peut aussi intégrer des éléments de structure complémentaire en fonction de la localisation de l'ouvrage. Selon une caractéristiue de l'invention, la structure de l'ombrière est démontable et transportable dans l'enceinte avant mise en oeuvre de cette dernière. L'ombrière peut accueillir des panneaux photovoltaiques permettant une baisse des consommations électriques en provenance d'un réseau de distribution.

Bien entendu, les différentes variantes et formes de réalisation de l'invention peuvent être associées les unes avec les autres selon diverses combinaisons dans la mesure où elles ne sont pas incompatibles ou exclusives les unes des autres.

Par ailleurs, diverses autres caractéristiques de l'invention ressortent de la description annexée effectuée en référence aux dessins qui illustrent une forme non limitative de réalisation d'une enceinte de data-center conforme à l'invention.
- La figure 1 est une perspective schématique d'une enceinte de data-center selon l'invention.
- La figure 2 est une coupe longitudinale schématique, en vue de dessus, de l'enceinte de data-center illustrée à la figure 1.
- La figure 3 est une perspective schématique partiellement arrachée de l'enceinte de data-center représentée à la figure 1, vue depuis la zone froide.
- La figure 4 est une perspective schématique partiellement arrachée de l'enceinte de data-center représentée à la figure 1, vue depuis l'extrémité d'accès à la zone froide
- La figure 5 est une perspective schématique en coupe transversale de l'enceinte de data-center représentée à la figure 1.
- La figure 6 est une perspective schématique montrant une installation de data-center mettant en oeuvre l'enceinte de data-center, représentée aux figures 1 à 5, équipée d'installations de traitement de l'air et associée à un groupe électrogène de secours.
- La figure 7 est une coupe longitudinale schématique, en vue de dessus, d'une variante de réalisation l'enceinte de data-center selon l'invention.
- La figure 8 illustre en perspectives schématique différentes variante d'installations de data-center mettant en oeuvre une enceinte selon l'invention associée à une ombrière.
Il est à noter que sur ces figures les éléments structurels et/ou fonctionnels communs aux différentes variantes peuvent présenter les mêmes références.

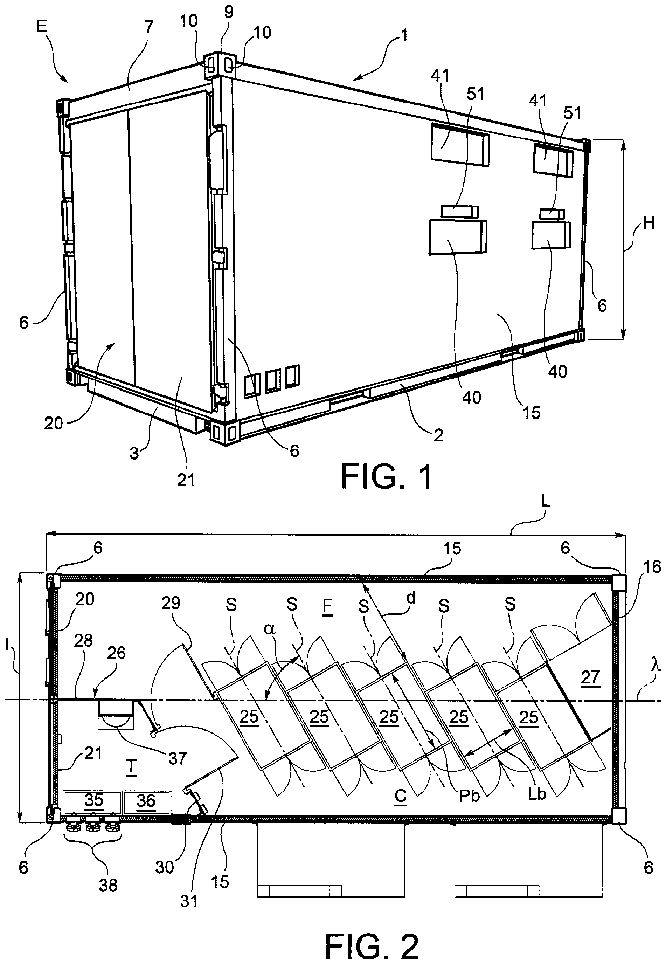

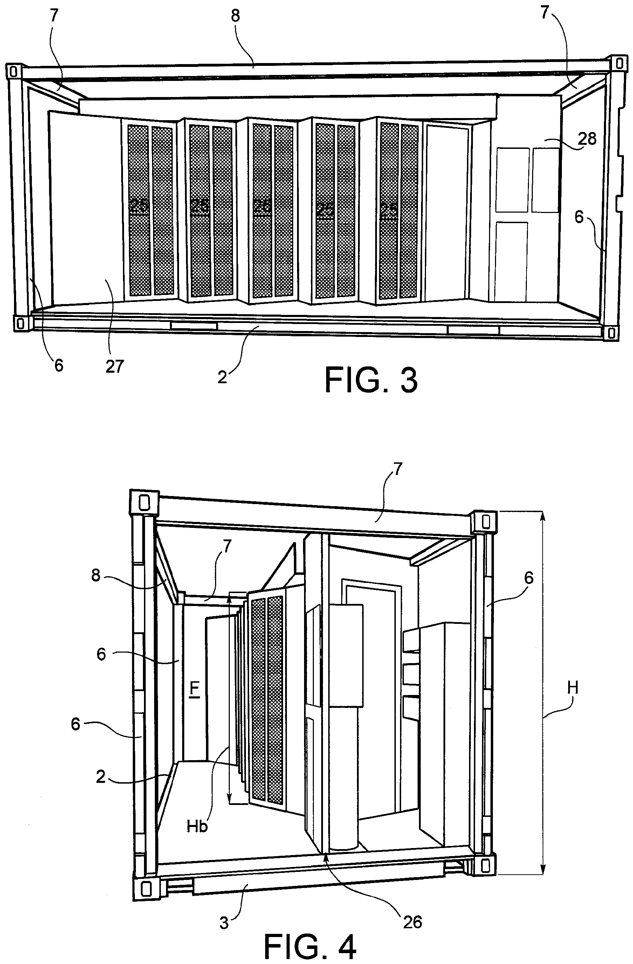

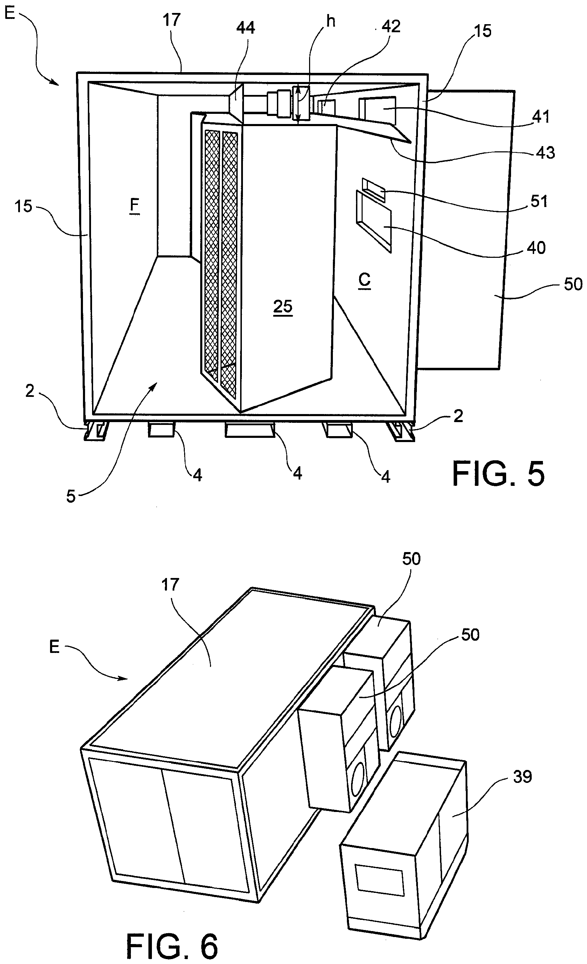

Une enceinte de data-center selon l'invention et telle que représentée aux figures 1 à 5, présente une forme générale parallélépipédique rectangle au gabarit routier européen. Dans le cas présent, l'enceinte selon l'invention désignée dans son ensemble par la référence E se présente sous la forme d'une enveloppe métallique au gabarit routier européen comprenant une structure porteuse 1 de forme générale parallélépipédique allongée selon un axe longitudinal λ. La structure porteuse 1 comprend deux longerons inférieurs 2 et deux traverses inférieures 3 formant la base du parallélépipède. La structure porteuse 1 comprend également trois poutres longitudinales 4 qui sont liées de manière rigide aux traverses inférieures 3 et qui supportent avec ces dernières un plancher 5.

La structure porteuse 1 comprend également quatre poteaux d'angle 6 qui sont liés de manière rigide aux traverses inférieures 3 et aux longerons inférieurs 2 et qui forment les quatre arêtes verticales extérieures de l'enceinte 6. La structure porteuse 1 comprend enfin deux traverses supérieures 7 et deux longerons supérieurs 8 qui sont liés de manière rigide au sommet des poteaux d'angle 6. Il doit être noté que les huit coins de la structure porteuse sont formés par des pièces d'angle 9 comprenant des lumières d'ancrage et de manutention.

La structure porteuse 1 est fermée au niveau de ses deux faces verticales longitudinales, de l'une de ses extrémités et de sa face supérieure par des parois latérales longitudinales 15, une paroi latérale extrême 16 et un paroi supérieure 17 qui sont fixes et qui comprennent chacune des faces intérieure et extérieure, de préférences métalliques, séparées par un isolant thermique. L'autre paroi latérale extrême de la structure porteuse 1 est également fermée et comprend, d'une part, une porte 20 d'accès à l'intérieur de l'enceinte qui est articulée sur un poteau d'angle 6 et, d'autre part, un panneau de fermeture 21. La porte 20 et le panneau de fermeture 21 présentent chacun des faces intérieure et extérieure, de préférence métalliques, séparées par un isolant thermique. Le panneau de fermeture 21 peut alors être lié de manière rigide à la structure porteuse 1 ou, au contraire, être articulé sur le poteau d'angle 6 correspondant.

L'enceinte E de data-center ainsi constituée par la structure porteuse 1, les parois longitudinales 15, la paroi latérale extrême 16, la paroi supérieure 17, le panneau de fermeture 21 et la porte 20 possède une longueur hors tout L supérieure ou égale à 500 cm et de préférence comprise entre 500 cm et 1300 cm et, par exemple, de l'ordre de 580 cm. L'enceinte de data-center possède également une largeur ℓ hors tout supérieure ou égale à 230 cm et de préférence comprise entre 230 cm et 250 cm et, par exemple de l'ordre de 240 cm. La hauteur H hors tout de l'enceinte E est comprise entre 220 cm et 300 cm et par exemple de l'ordre de 275 cm.

L'enceinte E est destinée à accueillir la majeure partie de l'équipement informatique, de distribution d'électricité, de communication et de sécurité nécessaire à un data-center conforme à l'état de l'art. À cet effet, l'enceinte E comprend à l'intérieur de l'espace qu'elle délimite au moins quatre baies 25 d'accueil de systèmes informatiques et/ou de télécommunications qui contribuent à délimiter dans l'enceinte E une zone froide F située à l'avant des baies d'accueil 25 et une zone chaude C située à l'arrière des baies 25. Selon l'exemple illustré, l'enceinte comprend E cinq baies d'accueil 25 juxtaposées.

L'enceinte E comprend, en outre, un cloisonnement intérieur 26 qui intègre les baies d'accueil 25 et qui sépare la zone froide F et la zone chaude C.

Selon l'exemple illustré, le cloisonnement intérieur 26 comprend un placard 27 qui assure la continuité du cloisonnement entre la paroi extrême 16 et la dernière baie d'accueil 25 adjacente. À l'opposé de la paroi latérale extrême 16, le cloisonnement intérieur 26 comprend une paroi intérieure 28 qui relie le panneau de fermeture 21 à la première baie d'accueil 25. La paroi 28 comprend en outre une porte 29 qui permet d'accéder à la zone chaude C à partir de la zone froide F.

Dans le cas présent, le cloisonnement intérieur 26 comprend aussi une cloison 30 qui sépare la zone chaude C d'un local technique T et qui comprend une porte 31 permettant un accès au local technique T à partir de la zone chaude C. Le local technique T comprend alors des systèmes 35 de distribution d'électricité et de sécurité électrique ainsi que des systèmes 36 de raccordement à un réseau de télécommunication. Le local technique renferme également un système 37 de protection contre l'incendie par injection de gaz neutre. Selon l'exemple illustré, le local technique T se trouve dans l'angle délimité par le panneau de fermeture 21 et la paroi latérale longitudinale 15 bordant la zone chaude C. L'enceinte E comprend aussi un câblage, non visible aux figures, de distribution d'énergie et de raccordement aux réseaux de communications qui s'étend entre le local technique et les baies d'accueil de manière à permettre l'alimentation électrique de leur équipement et le raccordement de ces derniers aux réseaux de communications autant que nécessaire. Par ailleurs, le système de distribution électrique 35 comprend un ensemble de prises externe 38 permettant un raccordement à un réseau de distribution électrique, à un groupe électrogène de secours et éventuellement à un système de batterie et d'onduleurs. Le système de distribution électrique est alors adapté pour utiliser le système de batterie d'onduleurs ainsi que le groupe électrogène 39 en cas de défaillance du réseau de distribution électrique. Il doit être noté que le système de batterie et d'onduleur peut également être disposé dans l'enceinte E et, par exemple, dans une baie d'accueil 25.

Afin de permettre une régulation de la température de l'air dans l'enceinte E, notamment au niveau des baies d'accueil 25, la paroi latérale longitudinale 15 bordant la zone chaude C comprend au moins une ouverture de circulation d'air chaud 40 et au moins une ouverture de circulation d'air froid 41. Selon l'exemple illustré, la paroi latérale longitudinale 15 comprend deux ouvertures de circulation d'air chaud 40 qui sont disposées sensiblement à mi-hauteur de la paroi latérale longitudinale 15 et qui débouchent dans la dans la zone chaude C. Dans le cas présent, La paroi latérale longitudinale 15 comprend deux ouvertures de circulation d'air froid 41 qui sont disposés dans le haut de la paroi latérale longitudinale en étant situés chacune au-dessus d'une ouverture de circulation d'air chaud 41. Les ouvertures de circulation d'air froid 41 débouchent dans une gaine de circulation d'air froid 42 qui est délimitée par la paroi supérieure 17 et un faux plafond 43 aménagé dans la zone chaude C jusqu'au dessus des baies d'accueil 25. La gaine de circulation d'air froid 42 s'ouvre dans la partie haute de la zone froide au-dessus des baies d'accueil 25 par une grille de ventilation 44. Le faux plafond 43 forme donc une partie du cloisonnement intérieur 26. Les deux ensembles d'ouvertures de circulation d'air superposées 40,41 sont alors chacun destinés à être accordés à une unité 50 de traitement de l'air fixée sur la face extérieure de la paroi latérale longitudinale 15. L'enceinte E selon la forme de réalisation illustrée est destinée à être associée à deux l'unité de traitement de l'air 50.

Chaque unité de traitement 50 est adaptée pour aspirer l'air par l'ouverture de circulation d'air chaud 40 correspondant et souffler de l'air par l'ouverture de circulation d'air froid 41 située au-dessus. Dans le cas présent, chaque unité de traitement 50 comprend une machine frigorifique adaptée pour au moins refroidir l'air aspiré par l'ouverture de circulation d'air chaud 40 et refoulé par l'ouverture de circulation d'air froid 41. Le cas échéant, chaque unité de traitement 50 peut également comprendre des moyens de chauffage de l'air ainsi que un système permettant de prélever de l'air extérieur pour l'insuffler après filtration dans la gaine de circulation d'air froid 42. Il doit être noté que, dans le cas présent, la paroi latérale longitudinale 15 comprend, au-dessus de chaque ouverture de circulation d'air chaud 40, une fenêtre 51 permettant d'accéder à un panneau de contrôle de l'unité de traitement 50 correspondante.

Afin d'optimiser l'espace intérieur de l'enceinte E, chaque baie d'accueil 25 possède une largeur Lb supérieure ou égale à 60 cm, une profondeur Pb supérieure ou égale à 90 cm et une hauteur Hb supérieure ou égale à 1,90 m. Ainsi chaque baie d'accueil peut être formée par une baie de type 42U. De manière préférée, les baies d'accueil 25 sont disposées de manière à permettre un retrait et une insertion, dans le cloisonnement intérieur 26, de l'une au moins des baies d'accueil 25 ainsi qu'une évacuation à l'extérieur de l'enceinte de ladite baie par la porte d'accès 20 sans déplacer les autres baies d'accueil 25. De manière préférée, les baies d'accueil 25 sont juxtaposées en épi de manière qu'un plan sagittal S de chaque baie 25 forme un angle aigu a, orienté vers la porte 20, avec l'axe longitudinal λ de l'enceinte E. Il est à noter que l'axe longitudinal λ est contenu dans un plan sagittal de l'enceinte E. L'angle α est, de préférence, compris entre 35° et 85° et de préférence de l'ordre de 60°. De plus, la plus petite distance d entre la face avant d'une baie d'accueil 25 et la paroi en regard de l'enceinte, mesurée parallèlement au plan sagittal de ladite baie, est supérieure ou égale à 90 cm.

Une telle disposition des baies d'accueil 25 permet, d'une part, comme cela a été dit plus haut de changer chacune des baies d'accueil 25 de manière individuelle sans devoir déplacer les autres baies et, d'autre part, de pouvoir mettre en place sans difficulté dans chacune des baies des systèmes informatiques rackables d'une même profondeur que chaque baie d'accueil 25.

Conformément à une caractéristique essentielle de l'invention et de manière à permettre un traitement efficace de l'air, le cloisonnement intérieur 26 est adapté pour que la circulation de l'air entre la zone froide F et la zone chaude C se fasse principalement au travers des baies d'accueil 25. Par ailleurs, de manière préférée, la gaine de circulation d'air froid 42 possède une hauteur supérieure ou égale à 10 cm de façon à ne pas induire des pertes de charges trop élevées.

Ainsi, lors de l'exploitation de l'enceinte E en tant que data-center les systèmes informatiques équipant chacune des baies d'accueil aspirent l'air de la zone froide F pour le refouler dans la zone chaude C. L'air de la zone chaude est ensuite évacué par les ouvertures de circulation d'air chaud 40 tandis que de l'air frais est insufflé ou aspiré par les ouvertures de circulation d'air froid 41 vers la zone froide.

Bien entendu, la forme de réalisation de l'enceinte de data-center selon l'invention illustrée aux figures 1 à 6 et décrite précédemment, peut faire l'objet de différents aménagements dans le cadre des revendications annexées.

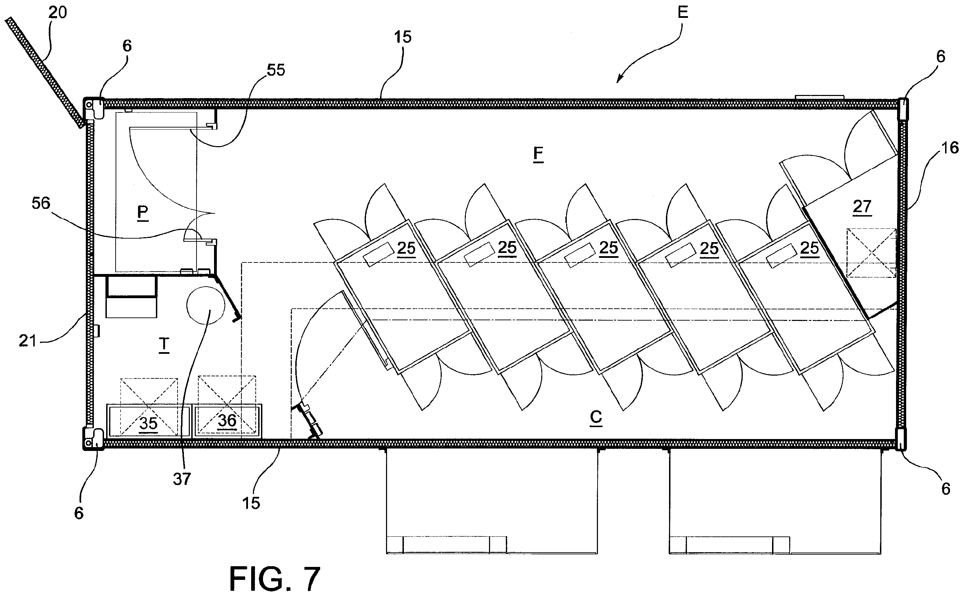

Ainsi la figure 7, illustre une variante de réalisation de l'enceinte de data-center selon l'invention dont le local technique T est ouvert vers la zone froide F. De plus, sur l'enceinte E comprend au niveau de la porte d'accès 20 un sas de propreté qui est séparé de la zone froide F par une porte à deux battants 55,56. Sur cette figure, la limite 57 du faux plafond délimitant la gaine 42 de circulation de l'air froid est illustrée par un trait mixte fort. Enfin, selon cette variante de réalisation, le raccordement aux réseaux de de fourniture d'énergie voire à une source de secours s'effectue par le dessous de l'enceinte sans recourir à des prises de branchement situées sur une paroi latérale. De même, le raccordement aux réseaux de communication s'effectue également par le desous de l'enceinte E.

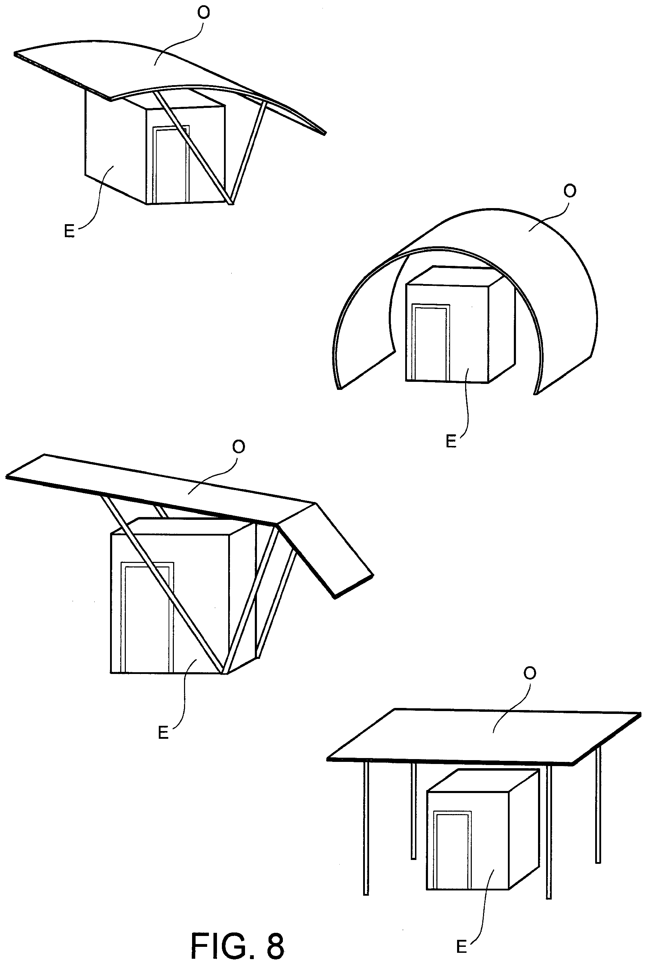

La figure 8 montre différentes variantes d'installations de data-center mettant en oeuvre une enceinte E selon l'invention associée à une ombrière O permettant de limiter l'exposition aux rayons solaires de l'enceinte E de manière à réduire les besoins en refroidissement.

Dans les exemples décrits précédemment l'enceinte E est réalisée en métal et plus particulièrement en acier. Toutefois, l'enceinte selon l'invention peut aussi être réalisée en aluminium et n'est pas nécessairement en métal. Elle peut aussi être réalisée en bois.

## Revendications

1. Enceinte de centre de traitement de données ou data-center de forme générale parallélépipédique rectangle au gabarit routier, allongée selon un axe longitudinal horizontal (λ), comprenant des baies d'accueil (25) de systèmes informatiques chacune de forme générale parallélépipédique rectangle allongée selon un axe vertical **caractérisée en ce qu'**elle comprend à l'intérieur de l'espace qu'elle délimite :
- au moins quatre baies d'accueil (25) de systèmes informatiques et/ou de télécommunications qui contribuent à délimiter dans l'enceinte une zone froide (F) à l'avant des baies d'accueil (25) et une zone chaude (C) à l'arrière des baies d'accueil (25), qui sont juxtaposées en épi et dont un plan sagittal (S) forme un angle aigu (α) compris entre 35° et 85° avec l'axe longitudinal de l'enceinte (λ),
- et un cloisonnement intérieur (26) qui sépare la zone froide (F) de la zone chaude (C) et qui intègre les baies d'accueil (25), le cloisonnement intérieur (26) étant adapté pour que la circulation de l'air entre la zone froide (F) et la zone chaude (C) se fasse principalement au travers des baies d'accueil (25),
la disposition des baies d'accueil (25) étant adaptée pour permettre un retrait et une insertion, dans le cloisonnement intérieur (26), de l'une des baie ainsi qu'une évacuation à l'extérieur de l'enceinte de ladite baie par une porte d'accès (20) située au niveau d'une paroi latérale extrême de l'enceinte, sans déplacer les autres baies d'accueil (25).

2. Enceinte de data-center selon la revendications 1, **caractérisée en ce que** la plus petite distance (d) entre la face avant d'une baie d'accueil (25) et la paroi en regard de l'enceinte, mesurée parallèlement à un plan sagittal de ladite baie, est supérieure ou égale à 90 cm.

3. Enceinte de data-center selon l'une des revendications précédentes, **caractérisée en ce que** chaque baie d'accueil possède une largeur (Lb) supérieure ou égale à 60 cm, une profondeur (Pb) supérieure ou égale à 90 cm et une hauteur (Hb) supérieure ou égale à 1,90 m.

4. Enceinte de data-center selon l'une des revendications précédentes, **caractérisée en ce qu'**elle possède une largeur (ℓ) hors-tout supérieure à 230 cm, une longueur (L) hors-tout supérieure à 500 cm et une hauteur (H) hors tout comprise entre 220 cm et 300 cm.

5. Enceinte de data-center selon l'une des revendications précédentes, **caractérisée en ce qu'**au moins les parois latérales (15,16) et la paroi supérieure (17) de l'enceinte comprennent un isolant thermique.

6. Enceinte de data-center selon l'une des revendications précédentes, **caractérisée en ce que** le cloisonnement comprend une porte (29) d'accès à la zone chaude (C) à partir de la zone froide (F).

7. Enceinte de data-center selon l'une des revendications précédentes, **caractérisée en ce qu'**elle comprend une porte d'accès (20) située au niveau d'une paroi latérale extrême de l'enceinte et donnant accès à la zone froide (F) depuis l'extérieur de l'enceinte.

8. Enceinte de data-center selon l'une des revendications précédentes, **caractérisée en ce qu'**une paroi latérale (16) de l'enceinte comprend au moins une ouverture de circulation d'air chaud (40) et au moins une ouverture de circulation d'air froid (41).

9. Enceinte de data-center selon la revendication précédente, **caractérisée en ce que** la paroi latérale (16) de l'enceinte comprenant les ouvertures de circulation d'air chaud (40) et d'air froid (41) est située du coté de la zone chaude (C).

10. Enceinte de data-center selon la revendication précédente, **caractérisée en ce qu'**elle comprend, dans la zone chaude (C), une gaine (42) de circulation d'air froid qui est raccordée à l'ouverture de circulation d'air froid (41) et qui débouche dans la zone froide (F).

11. Enceinte de data-center selon la revendication précédente, **caractérisée en ce que** la gaine de circulation d'air froid (42) est définie en partie au moins par une paroi supérieure (17) de l'enceinte et un faux-plafond (43).

12. Enceinte de data-center selon la revendication précédente, **caractérisée en ce que** la gaine de circulation d'air froid (42) possède une hauteur (h) supérieure ou égale à 10 cm.

13. Enceinte de data-center selon l'une des revendications 10 à 12, **caractérisée en ce que** la gaine circulation d'air froid (42) débouche dans la zone froide (F) au dessus des baies d'accueil (25).

14. Installation de data-center comprenant au moins une enceinte de data-center (E) selon l'une des revendications 8 à 13 et au moins une unité de traitement de l'air (50) qui est fixée à la paroi latérale pourvue des ouvertures de circulation de l'air et qui est adaptée pour aspirer l'air à traiter par l'ouverture de circulation de l'air chaud et refouler de l'air traité par l'ouverture de circulation d'air froid.

15. Installation de data-center selon la revendication 14, **caractérisé en ce qu'**elle comprend une ombrière (O) associée à l'enceinte (E).

## Patentansprüche

1. Gehäuse eines Datenverarbeitungs- oder Rechenzentrums mit im Wesentlichen einem sich entlang einer horizontalen Längsachse (λ) erstreckenden Quader entsprechender Form mit für den Straßentransport geeigneten Abmessungen, das Schächte (25) zum Aufnehmen von Informatiksystemen aufweist, die jeweils eine im Wesentlichen einem sich entlang einer senkrechten Achse erstreckenden Quader entsprechende Form aufweisen, **dadurch gekennzeichnet, daß** es im Inneren des Raums, den es definiert,
- wenigstens vier Schächte (25) zum Aufnehmen von Informatiksystemen und/oder Fernmeldesystemen, die dazu beitragen, im Gehäuse eine kalte Zone (F) vor den Aufnahmeschächten (25) und eine warme Zone (C) hinter den Aufnahmeschächten (25) abzugrenzen, die abgewinkelt nebeneinander angeordnet sind und deren Sagittalebene (S) mit der Gehäuselängsachse (λ) einen spitzen Winkel (α) zwischen 35° und 85° bildet,
- und eine innere Trennwand (26), die die kalte Zone (F) von der warmen Zone (C) trennt und die die Aufnahmeschächte enthält, wobei die innere Trennwand (26) derart ausgelegt ist, daß der Luftstrom zwischen der kalten Zone (F) und der warmen Zone (C) hauptsächlich durch die Aufnahmeschächte (25) erfolgt,
aufweist,
wobei die Anordnung der Aufnahmeschächte (25) dazu ausgelegt ist, ein Herausnehmen und ein Einsetzen eines der Schächte aus der bzw. in die innere Trennwand (26), sowie ein Entfernen des Schachts nach außerhalb des Gehäuses durch eine im Bereich einer Endseitenwand des Gehäuses gelegene Zugangstür (20) zu ermöglichen, ohne die anderen Aufnahmeschächte (25) zu verlagern.

2. Gehäuse eines Rechenzentrums gemäß Anspruch 1, **dadurch gekennzeichnet, daß** der kleinste Abstand (d) zwischen der Vorderseite eines Aufnahmeschachts (25) und der gegenüberliegenden Wand des Gehäuses, parallel zu einer Sagittalebene des Schachts gemessen, größer als oder gleich 90 cm ist.

3. Gehäuse eines Rechenzentrums gemäß einem der vorangehenden Ansprüche, **dadurch gekennzeichnet, daß** jeder Aufnahmeschacht eine Breite (Lb) von größer als oder gleich 60 cm, eine Tiefe (Pb) von größer als oder gleich 90 cm und eine Höhe (Hb) von größer als oder gleich 1,9 m hat.

4. Gehäuse eines Rechenzentrums gemäß einem der vorangehenden Ansprüche, **dadurch gekennzeichnet, daß** es eine Breite über Alles (*l*) von größer als oder gleich 230 cm, eine Länge über Alles (L) von 500 cm und eine Höhe über Alles (H) zwischen 200 cm und 300 cm hat.

5. Gehäuse eines Rechenzentrums gemäß einem der vorangehenden Ansprüche, **dadurch gekennzeichnet, daß** wenigstens die Seitenwände (15, 16) und die obere Wand (17) des Gehäuses eine Wärmeisolierung aufweisen.

6. Gehäuse eines Rechenzentrums gemäß einem der vorangehenden Ansprüche, **dadurch gekennzeichnet, daß** die Trennwand eine Tür (29) für den Zugang von der kalten Zone (F) zur warmen Zone (C) aufweist.

7. Gehäuse eines Rechenzentrums gemäß einem der vorangehenden Ansprüche, **dadurch gekennzeichnet, daß** es eine Zugangstür (20) aufweist, die sich im Bereich einer Endseitenwand des Gehäuses befindet und die von außerhalb des Gehäuses Zugang zur kalten Zone (F) gibt.

8. Gehäuse eines Rechenzentrums gemäß einem der vorangehenden Ansprüche, **dadurch gekennzeichnet, daß** eine Seitenwand (16) des Gehäuses wenigstens eine Öffnung (40) für den Umlauf warmer Luft und wenigstens eine Öffnung (41) für den Umlauf kalter Luft aufweist.

9. Gehäuse eines Rechenzentrums gemäß dem vorangehenden Anspruch, **dadurch gekennzeichnet, daß** sich die Seitenwand (16) des Gehäuses, die die Öffnungen für den Umlauf warmer Luft (40) bzw. für den Umlauf kalter Luft aufweist, auf der Seite der warmen Zone (C) befindet.

10. Gehäuse eines Rechenzentrums gemäß dem vorangehenden Anspruch, **dadurch gekennzeichnet, daß** es in der warmen Zone (C) einen Schlauch (42) für den Umlauf kalter Luft aufweist, der mit der Öffnung (41) für den Umlauf kalter Luft verbunden ist und der in die kalte Zone mündet.

11. Gehäuse eines Rechenzentrums gemäß dem vorangehenden Anspruch, **dadurch gekennzeichnet, daß** der Schlauch (42) für den Umlauf kalter Luft wenigstens zum Teil durch eine obere Wand (17) des Gehäuses und eine abgehängte Decke (43) definiert ist.

12. Gehäuse eines Rechenzentrums gemäß dem vorangehenden Anspruch, **dadurch gekennzeichnet, daß** der Schlauch (42) für den Umlauf kalter Luft eine Höhe (h) von größer als oder gleich 10 cm aufweist.

13. Gehäuse eines Rechenzentrums gemäß einem der Ansprüche 10 bis 12, **dadurch gekennzeichnet, daß** der Schlauch (42) für den Umlauf kalter Luft oberhalb der Aufnahmeschächte (25) in die kalte Zone (F) mündet.

14. Rechenzentrumsanlage, die wenigstens ein Gehäuse (E) eines Rechenzentrums gemäß einem der Ansprüche 8 bis 13 und wenigstens eine Luftaufbereitungseinheit (50) aufweist, die an der Seitenwand befestigt ist, die mit Öffnungen für den Umlauf von Luft versehen ist, und die dazu ausgelegt ist, die aufzubereitende Luft durch die Öffnung für den Umlauf warmer Luft anzusaugen und die aufbereitete Luft durch die Öffnung für den Umlauf kalter Luft auszustoßen.

15. Rechenzentrumsanlage gemäß Anspruch 14, **dadurch gekennzeichnet, daß** sie einen dem Gehäuse (E) zugeordneten Schattenspender (O) aufweist.

## Claims

1. A data-processing-centre or data-centre enclosure having a generally rectangular parallelepiped shape suitable for road transport, elongated along a horizontal longitudinal axis (λ), comprising computer system docking bays (25), each having a generally rectangular parallelepiped shape elongated along a vertical axis, **characterized in that** it comprises, inside the space delimited thereby:
- at least four computer and/or telecommunication system docking bays (25) that contribute to delimit within the enclosure a cold area (F) on the front of the docking bays (25) and a hot area (C) on the rear of the docking bays (25), which are juxtaposed to each other in an angled arrangement and whose sagittal plane (S) forms an acute angle (α) comprised between 35° and 85° with respect to the longitudinal axis of the enclosure (λ), and
- an inner partitioning (26) that separates the cold area (F) from the hot area (C) and that integrates the docking bays (25), the inner partitioning (26) being adapted so that the circulation of air between the cold area (F) and the hot area (C) mainly occurs through the docking bays (25),
the arrangement of the docking bays (25) being adapted to allow a removal from and insertion into the inner partitioning (26) of one of the bays as well as an evacuation of said bay out the enclosure through an access door (20) located at an end lateral wall of the enclosure, without moving the other docking bays (25).

2. The data-centre enclosure according to claim 1, **characterized in that** the smallest distance (d) between the front face of a docking bay (25) and the opposite wall of the enclosure, measured parallel to a sagittal plane of said bay, is higher than or equal to 90 cm.

3. The data-centre enclosure according to any one of the preceding claims, **characterized in that** each docking bay has a width (Lb) higher than or equal to 60 cm, a depth (Pb) higher than or equal to 90 cm, and a height (Hb) higher than or equal to 1.90 m.

4. The data-centre enclosure according to any one of the preceding claims, **characterized in that** it has an overall width (I) higher than 230 cm, an overall length (L) higher than 500 cm and an overall height (H) comprised between 220 cm and 300 cm.

5. The data-centre enclosure according to any one of the preceding claims, **characterized in that** at least the lateral walls (15, 16) and the upper wall (17) of the enclosure comprise a heat insulator.

6. The data-centre enclosure according to any one of the preceding claims, **characterized in that** the partitioning comprises a door (29) for access to the hot area (C) from the cold area (F).

7. The data-centre enclosure according to any one of the preceding claims, **characterized in that** it comprises an access door (20) located at an end lateral wall of the enclosure and giving access to the cold area (F) from the outside of the enclosure.

8. The data-centre enclosure according to any one of the preceding claims, **characterized in that** a lateral wall (16) of the enclosure comprises at least one hot air circulation opening (40) and at least one cold air circulation opening (41).

9. The data-centre enclosure according to the preceding claim, **characterized in that** the enclosure lateral wall (16) comprising the hot air (40) and cold air (41) circulation openings is located on the side of the hot area (C).

10. The data-centre enclosure according to the preceding claim, **characterized in that** it comprises, in the hot area (C), a cold air circulation duct (42) that is connected to the cold air circulation opening (41) and that opens into the cold area (F).

11. The data-centre enclosure according to the preceding claim, **characterized in that** the cold air circulation duct (42) is defined at least in part by an upper wall (17) of the enclosure and a false ceiling (43).

12. The data-centre enclosure according to the preceding claim, **characterized in that** the cold air circulation duct (42) has a height (h) higher than or equal to 10 cm.

13. The data-centre enclosure according to the any one of claims 10 to 12, **characterized in that** the cold air circulation duct (42) opens into the cold area (F) above the docking bays (25).

14. A data-centre installation comprising at least one data-centre enclosure (E) according to one of claims 8 to 13 and at least one air processing unit (50) that is fastened to the lateral wall devoid of the air circulation openings and that is adapted to suck the air to be processed through the hot air circulation opening and to discharge processed air through the cold air circulation opening.

15. The data-centre installation according to claim 14, **characterized in that** it comprises a shade (O) associated with the enclosure (E).
